Europäisches Patentamt

European Patent Office

Office européen des brevets

(19)

(11) Veröffentlichungsnummer: **0 404 026**
**A2**

## (12) EUROPÄISCHE PATENTANMELDUNG

(21) Anmeldenummer: **90111480.1**

(22) Anmeldetag: **18.06.90**

(51) Int. Cl.5: **H01L 27/092**

(30) Priorität: **22.06.89 DE 3920531**

(43) Veröffentlichungstag der Anmeldung:
**27.12.90 Patentblatt 90/52**

(84) Benannte Vertragsstaaten:
**AT DE FR GB IT NL**

(71) Anmelder: **Siemens Aktiengesellschaft**
**Wittelsbacherplatz 2**
**D-8000 München 2(DE)**

(72) Erfinder: **Wichmann, Bernhard, Dipl.-Phys.**
**Parkstrasse 2a**
**D-8011 Pöring(DE)**

(54) Schaltung zur Reduzierung der Latch-up Empfindlichkeit eines CMOS-Schaltkreises.

(57) Bei der erfindungsgemäßen Schaltung in CMOS-Technik wird die Latch-up Empfindlichkeit gegenüber Störungen am Ausgangspegel ($V_{OUT}$), die Minoritätsträger (14) in das Halbleitersubstrat (1) injizieren, dadurch reduziert, daß zwischen den beiden komplementären Transistoren ein dritter MOS-Transistor im Halbleitersubstrat (1) angeordnet ist, dessen Gate (31) auf einem Versorgungspotential und dessen Source (5) auf dem Ausgangspotential liegt. Das als Drain (30) wirkende dotierte Gebiet dieses dritten Transistors, das auf dem anderen Versorgungspotential liegt, entzieht dem Halbleitersubstrat (1) die injizierten Minoritätsträger (14), indem der dritte Transistor je nach Größe der Störung am Ausgang ($V_{OUT}$) entweder als Bipolartransistor in Basisschaltung mit hoher Stromverstärkung wirkt, wobei die Basis durch das Halbleitersubstrat (1) gebildet wird, oder als MOS-Transistor in Gateschaltung wirkt.

**FIG 3**

EP 0 404 026 A2

## Schaltung zur Reduzierung der Latch-up Empfindlichkeit eines CMOS-Schaltkreises.

Die Erfindung betrifft eine Schaltung zur Reduzierung der Latch-up Empfindlichkeit in komplementärer MOS-Technik nach dem Oberbegriff des Patentanspruchs 1.

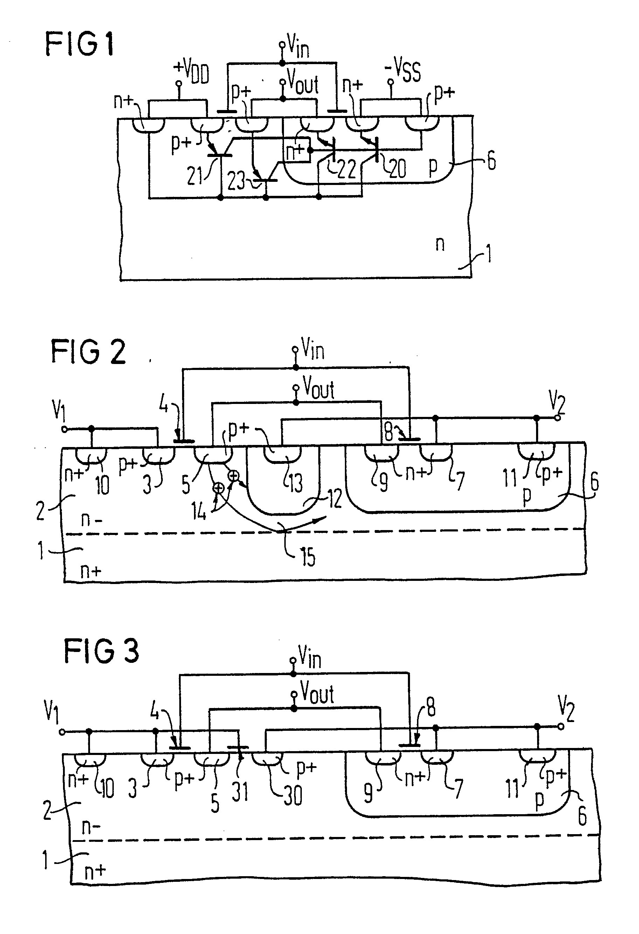

Bei der CMOS-Technologie ist die Gefahr eines Latch-up Effektes bekannt und in der Literatur beschrieben (R. Troutman, Latch-up in CMOS Technology, Kluwer Academic Publishers 1986; R. Muller, Device Electronics for Integrated Circuits, Wiley 1986). Unter Latch-up Effekt versteht man das Zünden eines parasitären Thyristors, der durch benachbarte komplementäre Transistoren der CMOS-Schaltung und der daraus resultierenden pnpn-Struktur gebildet wird. Der parasitäte Thyristor ist aus zwei Bipolar-Transistoren zusammengesetzt und unter normalen Betriebsbedingungen gesperrt. Wie in Figur 1 schematisch dargestellt, liegt beispielsweise bei p-Wannen-Technologie in einer Wanne 6 ein vertikaler npn-Transistor 20 und in einem Halbleitersubstrat 1 ein horizontaler pnp-Transistor 21, wobei der Kollektor des einen Transistors gleichzeitig die Basis des anderen ist; entsprechend kann ein Thyristor mit einem von zwei parasitären Bipolartransistoren 22, 23, deren Emitter mit dem Ausgang $V_{OUT}$ verbunden sind, gebildet werden. Das Zünden des Thyristors kann zum Funktionsausfall und zur Zerstörung der Schaltung führen und durch Störungen, d. h. Spannungsspitzen, an einem der Anschlüsse $V_1$, $V_2$, $V_{IN}$, $V_{OUT}$ ausgelöst werden, wodurch dann je nach Vorzeichen der Störung Minoritätsträger oder Majoritätsträger in das Halbleitersubstrat 1 bzw. die Wanne 6 injiziert werden.

Um einen durch Minoritätsträger verursachten Latch-up Effekt zu unterdrücken, ist es bekannt, ein als Guardring bezeichnetes zusätzliches dotiertes Gebiet zwischen den beiden komplementären Transistoren anzuordnen und auf ein bestimmtes Potential zu legen, um die Ladungsträger abzusaugen. Dies ist besonders vorteilhaft, wenn auf einem hochdotierten Halbleitersubstrat eine niedrigdotierte Halbleiterschicht, z.B. mittels Epitaxie, aufgebracht ist, und die MOS-Transistoren in dieser hochohmigen Halbleiterschicht angeordnet sind. Minoritätsträger werden dann in dieser schwachdotierten Schicht verbleiben, da sie hier einen geringeren Widerstand erfahren als in dem hochdotierten Substrat.

Eine solche Schaltung ist aus der oben angegebenen Literaturstelle von A. Troutman, Seite 167 bekannt und in Figur 2 am Beispiel einer p-Wannentechnik dargestellt. Auf einem hochdotierten n + Halbleitersubstrat 1 ist eine schwachdotierte n-Epitaxieschicht 2 aufgebracht worden, in dieser sind ein erster MOS-Transistor, bestehend aus einer ersten Sourcestruktur 3, einem Gate 4 und einer ersten Drainstruktur 5, angeordnet. In einer p-dotierten Wanne 6 in der Epitaxieschicht 2 befindet sich ein zweiter komplementärer MOS-Transistor, bestehend aus einer zweiten Sourcestruktur 7, einem zweiten Gate 8 und einer zweiten Drainstruktur 9. Die Source- und Drainstrukturen 3, 5, 7, 9 sind durch eindiffundierte hochdotierte Gebiete realisiert. Die Gates 4, 8 beider Transistoren sind an einen Eingang $V_{IN}$, die Drainstrukturen 5,9 sind an einen Ausgang $V_{OUT}$ angeschlossen. Die erste Sourcestruktur 3 ist an ein erstes Versorgungspotential $V_1$, die zweite Sourcestruktur 7 an ein zweites Versorgungspotential $V_2$ angeschlossen; in diesem Fall gilt $V_1 > V_2$. Das Halbleitersubstrat 1 ist über einen Substratanschluß 10 in der Epitaxieschicht 2 an das erste Versorgungspotential $V_1$, die Wanne 6 über einen Wannenanschluß 11 an das zweite Versorgungspotential $V_2$ angeschlossen. Ein zusätzlich eindiffundiertes p-dotiertes Gebiet, der Guardring 12, ist über einen Guardringanschluß 13 ebenfalls an $V_2$ angeschlossen. Durch den Guardring 12 werden Minoritästräger 14, die bei Störungen am Ausgang $V_{OUT}$ (d.h. wenn $V_{OUT} > V_1$) in die Epitaxieschicht 2 injiziert werden, abgesaugt und erreichen nicht die p-Wanne 6.

Bei hohen injizierten Strömen wird die Effektivität eines solchen Guardrings 12 dadurch verringert, daß die Minoritätsträger 14 durch einen Tunnel 15 zwischen der Unterkante des Guardrings 12 und der Grenzfläche zwischen Halbleiterschicht 2 und Halbleitersubstrat 1 zur Wanne 6 gelangen. Um die Wahrscheinlichkeit dafür zu reduzieren, muß dieser Tunnel 15 einen kleinen Querschnitt besitzen und/oder sehr lang sein. Im ersten Fall muß die Tiefe des als Guardring 12 wirkenden diffundierten Gebietes groß und gut einstellbar sein, im zweiten Fall muß die laterale Ausdehnung des diffundierten Gebietes 12 groß sein; der Guardring 12 beansprucht also viel Platz auf der Halbleiteroberfläche. Beide Lösungen sind daher in der Praxis mit Nachteilen verbunden.

Aufgabe der vorliegenden Erfindung ist es daher, eine Schaltung anzugeben, bei der auch bei großen Störungen am Ausgangspegel in das Substrat injizierte Minoritätsträger mit hoher Effektivität entfernt werden und die Latch-up Empfindlichkeit reduziert wird.

Diese Aufgabe wird bei einer Schaltung der eingangs genannten Art durch die kennzeichnenden Merkmale des Patentanspruchs 1 gelöst. Weiterbildungen der Erfindung sind Gegenstand von Unteransprüchen.

Die Erfindung wird nachfolgend anhand von Ausführungsbeispielen näher erläutert, die in der Zeichnung dargestellt sind. Es zeigen

FIG 1 einen Querschnitt durch eine CMOS-Schaltung mit schematischer Darstellung der parasitären Bipolartransistoren,

FIG 2 eine CMOS-Schaltung mit herkömmlichen Maßnahmen zur Reduzierung der Latch-up Empfindlichkeit,

FIG 3 eine Ausführungsform der erfindungsgemäßen Schaltung.

In allen Figuren sind gleiche Teile mit gleichen Bezugzeichen bezeichnet.

Für die in Figur 3 dargestellte Ausführungsform der Erfindung wurde dieselbe Grundschaltung wie in Figur 2 gewählt, so daß im folgenden nur die erfindungswesentlichen Teile beschrieben werden. Zwischen der ersten Drainstruktur 5 und der Wanne 6 ist ein weiteres dotiertes Gebiet 30 vom selben Leitungstyp wie der erste Transistor als dritte Drainstruktur eines dritten Transistors angeordnet und an das zweite Versorgungspotential $V_2$ angeschlossen. Die erste Drainstruktur 5 ist in dieser Ausführungsform gleichzeitig eine dritte Sourcestruktur des dritten Transistors. Weiter ist zwischen der ersten Drainstruktur 5 und der dritten Drainstruktur 30 ein drittes Gate 31 des dritten Transistors vorgesehen, das an das erste Versorgungspotential $V_1$ angeschlossen wird. Vorzugsweise ist $V_2$ das Erdpotential (auch als $V_{SS}$ bezeichnet) und $V_1$ positiv (als $V_{DD}$ bezeichnet).

Der dritte Transistor erfüllt je nach Potential am Ausgang $V_{OUT}$, auf zwei verschiedene Weisen die Aufgabe, die Minoritätsträger 14 aus der schwach dotierten Halbleiterschicht 2 abzusaugen (mit $V_T$ ist die Schwellenspannung bezeichnet, wie in K.Horninger, Integrierte MOS-Schaltungen, Springer 1987, Seite 54 beschrieben):
Fall 1: $V_{DD} + V_T > V_{OUT} > V_{DD}$

Der dritte Transistor wirkt als Bipolartransistor, wobei der Emitter von der dritten Sourcestruktur (in dieser Ausführungsform identisch mit der ersten Drainstruktur 5), die Basis vom Substrat 1 bzw. der Halbleiterschicht 2 und der Kollektor von der dritten Drainstruktur 30 gebildet wird. Die anliegenden Potentiale betragen somit am Emitter $V_{OUT}$ an der Basis $V_{DD}$ ($< V_{OUT}$) und am Kollektor $V_{SS}$ ($= 0$); dieser Bipolartransistor erreicht eine etwa zehnmal größere Stromverstärkung als der parasitäre laterale Bipolartransistor 23.
Fall 2: $V_{OUT} > V_{DD} + V_T$

Der dritte Transistor wirkt als p-Kanal MOS-Transistor in Gateschaltung. Die Potentialdifferenz zwischen Source und Gate beträgt mindestens VT und ist so gepolt, daß der MOS-Transistor leitend wird. Auf diese Weise kann das Eintreten des Latch-up Effektes auch bei hohen Störungen am Ausgang $V_{OUT}$ verhindert werden.

Weitere Ausführungsformen:

1. Die in Figur 3 angegebene Verwendung einer schwach dotierten Halbleiterschicht 2 auf einem hoch dotierten Halbleitersubstrat 1 ist vorteilhaft, die erfindungsgemäße Schaltung kann aber auch dann eingesetzt werden, wenn die komplementären MOS-Transistoren direkt in einem Halbleitersubstrat 1 angeordnet sind.

2. Die dritte Sourcestruktur kann getrennt von der ersten Drainstruktur 5 im Halbleitersubstrat 1 bzw. der Halbleiterschicht 2 angeordnet werden und an den Ausgang $V_{OUT}$ angeschlossen werden.

**Ansprüche**

1. Schaltung zur Reduzierung der Latch-up Empfindlichkeit in komplementärer MOS-Technik, bei welcher
- ein erster MOS-Transistor eines ersten Leitungstyps in einem Halbleitersubstrat (1) angeordnet ist, das den komplementären zweiten Leitungstyp aufweist,
- ein zweiter MOS-Transitor des zweiten Leitungstyps in einer Wanne (6) im Halbleitersubstrat (1) angeordnet ist, die den ersten Leitungstyp aufweist,
- an ein erstes Versorgungspotential ($V_1$) das Halbleitersubstrat (1) und die Sourcestruktur (3) des ersten Transistors angeschlossen sind,
- an ein zweites Versorgungspotential ($V_2$) die Wanne (6) und die Sourcestruktur (7) des zweiten Transistors angeschlossen sind, **dadurch gekennzeichnet,** daß zwischen dem ersten und dem zweiten Transistor ein dritter Transistor des ersten Leitungstyps im Halbleitersubstrat (1) angeordnet ist, wobei
- das Gate (31) des dritten Transistors an das erste Versorgungspotential ($V_1$) angeschlossen ist,
- die Drainstruktur (30) des dritten Transistors an das zweite Versorgungspotential ($V_2$) angeschlossen ist,
- die Sourcestruktur des dritten Transistors an den Ausgang ($V_{OUT}$) angeschlossen ist

2. Schaltung nach Anspruch 1, **dadurch gekennzeichnet,** daß die Sourcestruktur des dritten Transistors dicht benachbart zur Drainstruktur (5) des ersten Transistors angeordnet ist.

3. Schaltung nach Anspruch 1, **dadurch gekennzeichnet,** daß die Sourcestruktur (5) des dritten Transistors überlappend zur Drainstruktur (5) des ersten Transistors angeordnet ist.

4. Schaltung nach einem der Ansprüche 1 bis 3, **dadurch kennzeichnet,** daß der erste Leitungstyp die p-Leitfähigkeit und der zweite Leitungstyp die n-Leitfähigkeit ist, das Halbleitersubstrat (1) n-dotiert und die Wanne (6) p-dotiert ist, und das erste Versorgungspotential ($V_1$) größer als das zweite Versorgungspotential ($V_2$) ist.

5. Schaltung nach einem der Ansprüche 1 bis 3, **dadurch gekennzeichnet,** daß der erste Leitungstyp die n-Leitfähigkeit und der zweite Leitungstyp die p-Leitfähigkeit ist, das Halbleitersubstrat(1)p-dotiert und die Wanne (6)n-dotiert ist, und das erste Versorgungspotential ($V_1$) kleiner als das zweite Versorgungspotential ($V_2$) ist.

6. Schaltung nach einem der Ansprüche 1 bis 5, **dadurch gekennzeichnet,** daß das Halbleitersubstrat (1) hochdotiert ist, auf diesem sich eine schwach dotierte Halbleiterschicht (2) desselben Leitungstyps befindet, und in der Halbleiterschicht (2) die Wanne (6) und die Transistoren angeordnet sind.

# FIG 1

$V_{in}$

$V_{out}$

$+V_{DD}$

$-V_{SS}$

n+

p+

n+

p+

p+

21   23   22   20

n+

p

6

n

1

# FIG 2

$V_{in}$

$V_{out}$

$V_1$

4

8

$V_2$

n+   10   p+   3   5   p+   13   9   n+   7   11   p+   6

14

12   p

2

n–

1

n+

15

# FIG 3

$V_{in}$

$V_{out}$

$V_1$

4

8

$V_2$

n+   10   3   p+   5   31   30   p+   9   n+   7   11   p+

2

n–

1

n+

p

6